# EUROPÄISCHE PATENTSCHRIFT

(11) **EP 1 042 819 B1**
(45) Veröffentlichungstag und Bekanntmachung des Hinweises auf die Patenterteilung: **24.01.2018**
(21) Anmeldenummer: 98965124.5
(22) Anmeldetag: 15.12.1998
(51) Int. Cl.: H01L 31/0203, H01L 33/48, H01L 33/58, H01L 31/0232

(54) **VERFAHREN ZUR HERSTELLUNG EINES OBERFLÄCHENMONTIERBAREN OPTOELEKTRONISCHEN BAUELEMENTES UND OBERFLÄCHENMONTIERBARES OPTOELEKTRONISCHES BAUELEMENT**
SURFACE-MOUNTED OPTOELECTRONIC COMPONENT AND METHOD FOR PRODUCING SAME
COMPOSANT OPTOELECTRONIQUE POUVANT ETRE MONTE EN SURFACE ET SON PROCEDE DE PRODUCTION

(30) Priorität: 15.12.1997 DE 19755734
(43) Veröffentlichungstag der Anmeldung: 11.10.2000
(73) Patentinhaber: OSRAM Opto Semiconductors GmbH, 93055 Regensburg (DE)
(72) Erfinder: WAITL, Günter, D-93049 Regensburg (DE); LUTZ, Robert, D-93077 Bad Abbach (DE); BRUNNER, Herbert, D-93047 Regensburg (DE)
(74) Vertreter: Epping - Hermann - Fischer
(86) Internationale Anmeldenummer: PCT/DE1998/003676
(87) Internationale Veröffentlichungsnummer: WO 1999/031737

(56) Entgegenhaltungen:
- EP-A- 0 230 336
- EP-A- 0 400 176
- WO-A-82/04500
- WO-A-83/00408
- JP-A- H0 927 643
- JP-A- H0 983 018
- US-A- 5 331 512
- PATENT ABSTRACTS OF JAPAN vol. 006, no. 170 (E-128), 3. September 1982 & JP 57 085273 A (TOSHIBA CORP), 27. Mai 1982
- PATENT ABSTRACTS OF JAPAN vol. 009, no. 136 (E-320), 12. Juni 1985 & JP 60 020587 A (SANYO DENKI KK;OTHERS: 02), 1. Februar 1985
- MOELLMER F ET AL: "SIEMENS-SMT-TOP-LED - LEDS FOR SURFACE MOUNTING PART 1: CHARACTERISTICS AND SPECIAL FEATURES" COMPONENTS, Bd. 26, Nr. 4 / 05, 1. Oktober 1991, Seiten 147-149, XP000266913 in der Anmeldung erwähnt

## Beschreibung

Die Erfindung betrifft ein Verfahren zur Herstellung eines oberflächenmontierbaren optoelektronischen Bauelementes, das einen Grundkörper, einen in einer Ausnehmung des Grundkörpers angeordneten optoelektronischen Sender und/oder Empfänger und eine die Ausnehmung verschließende optische Einrichtung aufweist, und ein oberflächenmontierbares optoelektronisches Bauelement.

In den letzten Jahren löst die Oberflächenmontagetechnik (SMT) zunehmend die Bestückung von Leiterbahnträgern mit bedrahteten Bauelementen ab. Der entscheidende Vorteil der SMT besteht in einer Steigerung der Packungsdichte, die mit herkömmlichen Bestückungverfahren nicht erreicht wird.

Wegen der bei vielen optischen Anwendungen gewünschten hohen Packungsdichte kommt der SMT im Bereich der Optoelektronik eine besondere Bedeutung zu. Es sind auch bereits optoelektronische Bauelemente bekannt, die nach dem SMT-Konzept oberflächenmontierbar ausgelegt sind.

Die Druckschriften JP H09 83018 A und JP H09 27643 A beschreiben jeweils ein Verfahren zur Herstellung eines oberflächenmontiebaren optoelektronischen Bauelements und ein oberflächenmontierbares optoelektronisches Bauelement.

EP 0 230 336 A1 beschreibt ein oberflächenmontierbares optoelektronisches Bauelement, das ein ringförmiges Gehäuse aufweist, dessen obere Ringöffnung mit einer Kugellinse verschlossen ist, während die untere Ringöffnung auf einer Platine aufsteht. Innerhalb des Gehäuses ist zwischen der Platine und dem unteren Scheitelpunkt der Kugellinse ein lichtaussendendes Halbleiterelement angeordnet. Der durch die Platinenoberfläche und die Kugellinse begrenzte Innenraum des Ringgehäuses ist mit einem transparenten Kleber gefüllt.

Ein weiteres oberflächenmontierbares optoelektronisches Bauelement ist in der EP 0 400 176 dargestellt. Dieses Bauelement weist einen Grundkörper mit einer zentralen Vertiefung auf, in der ein optisch aktives Halbleiterelement angeordnet ist. Oberhalb des Grundkörpers befindet sich eine Linse, die über eine Befestigungseinrichtung, beispielsweise einen Klemmzapfen, mit dem Grundkörper verbunden ist.

Aus "Siemens SMT-TOPLED für die Oberflächenmontage", Frank Möllmer und Günter Waitl, Siemens Components 26, (1991), Heft 4, Seiten 147 bis 149, ist eine für die Oberflächenmontage vorgesehene lichtemittierende Diode (LED) bekannt. Zur Herstellung dieser Diode wird ein endlos gestanztes Leiterband mit einem hochtemperaturfesten Thermoplast umspritzt, der den Gehäuserahmen bildet. Im Innenbereich des Gehäuserahmens wird ein optisch aktive Element auf das Leiterband montiert und an dort vorhandenen Leiterbahnen elektrisch kontaktiert. Nachfolgend wird der Rahmeninnenbereich zum Schutz des aktiven Elements vor Umwelteinflüssen mit einem Gießharz vergossen. Eine Linse oder eine ähnliche optische Einrichtung ist bei diesem Bauelement nicht vorgesehen.

Die in den beiden letztgenannten Dokumenten beschriebenen SMT-Optobauelemente weisen die Besonderheit auf, daß zunächst das komplette Bauteilgehäuse durch Umspritzen eines Leiterbandes mit einem Thermoplastmaterial hergestellt wird und der optoelektronische Sender und/oder Empfänger erst nach Fertigstellung des Thermoplastgehäuses in dieses eingesetzt wird. Die Vorteile dieses Herstellungsverfahrens liegen darin, daß es eine sehr kostengünstige Massenfertigung am Gurt (Leiterband) ermöglicht, und daß geringe Bauhöhen und standardisierte Grundbauformen in einfacher Weise realisierbar sind. Aufgrund ihrer geringen Kosten werden diese sogenannten vorgehäusten SMT-Optobauelemente vor allem in Anzeigenarrays und dergleichen verwendet.

Der vorliegenden Erfindung liegt die Aufgabe zugrunde, ein Verfahren anzugeben, mit dem die Abstrahl-Charakteristik von optoelektronischen SMT-Bauelemente der eingangs genannten Art verbessert werden kann, ohne dabei die Bauteilkosten in inakzeptabler Weise zu erhöhen. Ferner zielt die Erfindung darauf ab, ein derartiges optoelektronisches SMT-Bauelement mit gut definierbarer Abstrahl-Charakteristik und gleichzeitig niedrigen Bauteilkosten zu schaffen.

Diese Aufgabe wird gemäß der unabhängigen Ansprüche gelöst.

Nach dem Bereitstellen des Grundkörpers mit dem in der Ausnehmung angeordneten optoelektronischen Sender und/oder Empfänger, erfolgt ein Befüllen der Ausnehmung des Grundkörpers mit einer transparenten, härtbaren Vergußmasse und ein Aufbringen der optischen Einrichtung auf den Grundkörper, wobei die optische Einrichtung im Bereich der Ausnehmung mit der Vergußmasse in Kontakt tritt bevor die Vergußmasse und/oder die optische Einrichtung, falls diese ebenfalls eine Vergußmasse aufweist, vollständig ausgehärtet ist.

Ein wesentlicher Gesichtspunkt der vorliegenden Erfindung besteht darin, daß die optische Einrichtung erst nach dem Vergießen der Ausnehmung mit Vergußmasse auf den Grundkörper aufgebracht wird. Durch das Aufbringen der optischen Einrichtung auf die bereits mit Vergußmasse gefüllte Ausnehmung kann eine sehr lagegenaue und reproduzierbare Positionierung der optischen Einrichtung auf dem Grundkörper erfolgen, die durch nachfolgende Schritte wie beispielsweise einen Aushärteschritt oder einen Entformungsschritt im wesentlichen nicht mehr beeinträchtigt wird. Dadurch wird in bezug auf das Abstrahl- oder auch Empfangsverhalten eine hohe optische Qualität des optoelektronischen Bauelements gewährleistet, die für Anwendungen, bei denen eine exakte Strahlführung und eine hohe Lichtausbeute wünschenswert sind, von großer Bedeutung ist. Die erfindungsgemäßen optoelektronischen Bauelemente sind damit Bauelementen, bei denen die Befüllung der Ausnehmung von der rückwärtigen Seite bei zuvor montierter optischer Einrichtung erfolgt, überlegen.

Das erfindungsgemäße Verfahren läßt sich in besonders bevorzugter Weise bei der Herstellung von sogenannten vorgehäusten optoelektronischen Bauelementen anwenden. Dabei erfolgt zunächst die Herstellung des Grundkörpers durch Umspritzen eines Leiterbandes mit einem Thermoplast unter gleichzeitiger Ausbildung des Gehäuses mit der Ausnehmung und nachfolgend die Montage des optoelektronischen Senders und/oder Empfängers auf einen innerhalb der Ausnehmung liegenden Abschnitt des Leiterbandes.

Nach einer ersten besonders vorteilhaften Ausführungsform des erfindungsgemäßen Verfahrens wird die optische Einrichtung auf die noch nicht gehärtete Vergußmasse aufgebracht und wird die Vergußmasse nachfolgend ausgehärtet.

In diesem Fall kann die Befüllmenge der Vergußmasse so gewählt werden, daß beim nachfolgenden Aufbringen der optischen Einrichtung im wesentlichen keine Vergußmasse über den Rand der Ausnehmung hinaustritt. Es ist dann nicht erforderlich, Maßnahmen zum Auffangen etwaig übertretender Vergußmasse zu ergreifen.

Es ist auch möglich, eine aufgrund der Oberflächenspannung der Vergußmasse auftretende Hohlkehlenbildung derselben auszunutzen. In diesem Fall wird eine optische Einrichtung verwendet, deren Formgebung in ihrem die Vergußmasse kontaktierenden Bereich so gewählt ist, daß auch bei einer bis zum Rand mit Vergußmasse gefüllten Ausnehmung beim Aufbringen der optischen Einrichtung keine Vergußmasse über den Rand der Ausnehmung hinaustritt.

Der Grundkörper kann auch vor dem Aufbringen der optischen Einrichtung mit einer die Ausnehmung umlaufenden Ringnut versehen werden. In diesem Fall wird beim Aufbringen der optischen Einrichtung gegebenenfalls überlaufende Vergußmasse in der Ringnut gesammelt und somit verhindert, daß diese an der Außenseite des Grundkörpers herunterläuft und dort aushärtet, was die Handhabbarkeit des Bauelements beeinträchtigen würde.

Eine besonders reproduzierbare Positionierung der optischen Einrichtung wird erreicht, wenn der Grundkörper vor dem Aufbringen der optischen Einrichtung mit randseitig zur Ausnehmung angeordneten Auflageelementen für die optische Einrichtung versehen wird. Die Auflageelemente können beispielsweise in dem bereits erwähnten Spritzschritt zur Herstellung des Grundkörpers bei einem vorgehäusten optoelektronischen Bauelement integral mit dem Gehäuse gebildet werden.

Vorzugsweise wird die optische Einrichtung im wesentlichen druckfrei von oben auf den Grundkörper oder auf die an diesem ausgebildeten Auflageelemente aufgelegt. Die Ablage der optischen Einrichtung erfolgt dann allein aufgrund der Schwerkraft.

Eine weitere vorteilhafte Verfahrensvariante besteht darin, daß vor dem Aufbringen der optischen Einrichtung zunächst dieselbe mittels eines Gieß-, Preß- oder Spritzvorgangs hergestellt wird, nachfolgend als Schüttgut gefördert wird und durch automatisiertes Ergreifen aus dem Schüttgut und automatisiertes Positionieren über einem Grundkörper auf diesen aufgebracht wird. Der Vorteil dieser Maßnahmen besteht darin, daß die Herstellung der optischen Einrichtung völlig unabhängig von der Herstellung des Grundkörpers erfolgt, wodurch die Möglichkeit einer gesonderten und effektiven Qualitätskontrolle der optischen Einrichtung sowie der Aussonderung von Ausschuß gegeben ist. Dadurch wird die Herstellung von Bauelementen mit höchster Qualität ermöglicht.

Nach einer zweiten besonders bevorzugten Ausführungsform des erfindungsgemäßen Verfahrens wird die optische Einrichtung in einem Gießvorgang gebildet und im Rahmen dieses Gießvorgangs im Bereich der Ausnehmung auf den Grundkörper aufgebracht und mit der Vergußmasse in der Ausnehmung vergossen. Auch bei dieser zweiten Ausführungsform des erfindungsgemäßen Verfahrens erfolgt die Befüllung der Ausnehmung des Grundkörpers vor dem Aufbringen der optischen Einrichtung im Rahmen des erwähnten Gießschrittes, so daß die mit dieser Prozeßführung verbundenen Vorteile auch bei dieser Ausführungsform des erfindungsgemäßen Verfahrens zu Tage treten.

Vorzugsweise wird bei dieser zweiten Ausführungsform des erfindungsgemäßen Verfahrens zur Herstellung der optischen Einrichtung zunächst eine Gießformhälfte bereitgestellt und diese Gießformhälfte mit einer weiteren Vergußmasse befüllt. Andererseits wird nach dem Befüllen der Ausnehmung des Grundkörpers mit Vergußmasse die Vergußmasse zunächst zumindest teilweise gehärtet und danach mit Vergußmasse benetzt. Anschließend werden der Grundkörper und die mit der weiteren Vergußmasse befüllte Gießformhälfte lagerichtig zusammengefügt und in einem weiteren Schritt wird die weitere Vergußmasse in der Gießformhälfte ausgehärtet und dabei an die Vergußmasse in der Ausnehmung des Grundkörpers angegossen. Schlußendlich wird die Entformung des nunmehr fertiggestellten optoelektronischen Bauelements durch Entfernen der Gießformhälfte von dem Grundkörper mit angegossener optischer Einrichtung durchgeführt.

Die Benetzung kann beispielsweise dadurch erfolgen, daß der Grundkörper um eine Horizontalachse gewendet wird und zumindest oberflächenseitig in Vergußmasse eingetaucht wird. Aufgrund der zumindest teilweisen Aushärtung der Vergußmasse läuft bei dem Wenden keine Vergußmasse aus.

Durch die Benetzung der Oberfläche der Gußmasse wird verhindert, daß beim nachfolgenden Angußschritt Luftblasen in der Vergußmasse zurückbleiben.

Der Vorteil der vorstehend beschriebenen zweiten Ausführungsform des erfindungsgemäßen Verfahrens besteht darin, daß sie auf einfache Weise realisierbar ist und ein hohes Automatisierungspotential besitzt, wodurch insbesondere auch eine Massenfertigungen in Großserie ermöglicht wird.

Weitere vorteilhafte Ausgestaltungen der erfindungsgemäßen Verfahrens sind in den Unteransprüchen 2 bis 5 und des erfindungsgemäßen Bauelements in den Unteransprüchen 7 und 8 angegeben.

Die Erfindung wird nachfolgend in beispielhafter Weise unter Bezugnahme auf die Zeichnung beschrieben; in dieser zeigt:
- Fig. 1: eine perspektivische Ansicht eines in dem erfindungsgemäßen Verfahren verwendeten Grundkörpers mit Gehäuse und Leiterband;
- Fig. 2A, 2B, 2C: die Verfahrensschritte des Bereitstellens des Grundkörpers, des Befüllens der Ausnehmung des Grundkörpers und des Aufbringens der optischen Einrichtung auf den Grundkörper nach einer ersten Ausführungsform der vorliegenden Erfindung anhand des in Fig. 1 gezeigten Grundkörperbeispiels;
- Fig. 3: das in Fig. 2C gezeigte, nach der ersten Ausführungsform der vorliegenden Erfindung hergestellte optoelektronische Bauelement in Draufsicht;
- Fig. 4: eine schematische Darstellung zur Erläuterung der Herstellung und Förderung der optischen Einrichtung;
- Fig. 5: ein weiteres nach der ersten Ausführungsform des erfindungsgemäßen Verfahrens hergestelltes optoelektronisches Bauelement;
- Fig. 6: das in Fig. 5 gezeigte optoelektronische Bauelement in Draufsicht; und
- Fig. 7: eine schematische Darstellung zur Erläuterung einer weiteren Ausführungsform eines Verfahrens, das nicht durch diese Erfindung abgedeckt wird.

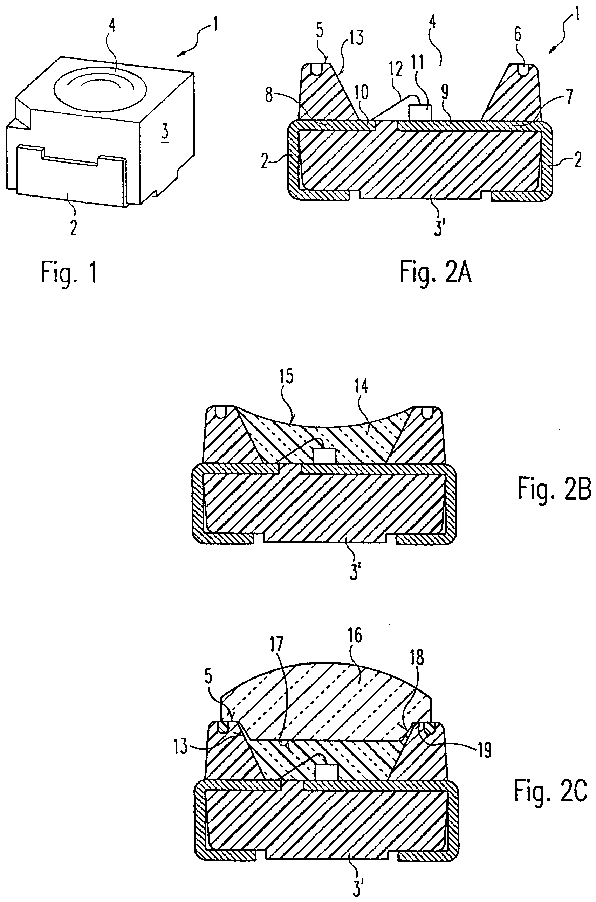

Fig. 1 zeigt einen Grundkörper 1, der durch Umspritzen eines Leiterbandes 2 mit einem Hochtemperatur-Thermoplastgehäuse 3 gebildet wird. Das Gehäuse 3 weist vorzugsweise ebene Außenflächen auf, um eine einfache Bestückbarkeit zu gewährleisten. Oberflächenseitig ist in dem Gehäuse 3 eine Ausnehmung 4 vorgesehen.

Fig. 2A zeigt eine Schnittdarstellung eines im wesentlichen gemäß Fig. 1 aufgebauten Grundkörpers 1, wobei sich das Gehäuse 3' von dem in Fig. 1 gezeigten Gehäuse 3 nur insoweit unterscheidet, daß die Oberfläche 5 des Gehäuses 3' mit einer die Ausnehmung 4 umlaufenden Ringnut 6 versehen ist, auf die später noch Bezug genommen wird. Fig. 2A zeigt, daß Abschnitte 7, 8 des Leiterbands 2 vom Thermoplastgehäuse 3' umschlossen sind und im bodenseitigen Bereich der Ausnehmung 4 mit Kontaktabschnitten 9, 10 in diese hineinstehen. Dabei ist ein Kontaktabschnitt 9 bis in den zentralen Bereich der Ausnehmung 4 hinein verlängert.

Die inneren Wandflächen 13 des Gehäuses 3 sind als Schrägflächen ausgeführt und bilden einen Reflektor. Durch die Wahl eines Gehäusewerkstoffs mit einem hohen diffusen Reflexionsgrad von etwa 90% oder mehr läßt sich eine hohe Reflektivität dieser Flächen 13 erzeugen.

Nach der Fertigstellung der Leiterband-Gehäusestruktur 2, 3' wird ein Halbleiterchip 11 in die Ausnehmung 4 des Gehäuses 3' montiert. In der Darstellung der Fig. 2A ist dieser Montageschritt bereits ausgeführt. Der Halbleiterchip 11 wird dabei auf den verlängerten Kontaktabschnitt 9 des Leiterbandes 2 aufgebracht und mit diesem elektrisch kontaktiert. Eine weitere elektrische Kontaktierung erfolgt über einen Draht 12, der von dem Halbleiterchip 11 zu dem gegenüberliegenden Kontaktabschnitt 10 des Leiterbandes 2 geführt ist. Als Halbleiterchip 11 kann beispielsweise eine lichtemittierende Diode oder ein photoempfindliches Halbleiterelement verwendet werden.

Nach der Montage und Kontaktierung des Halbleiterchips 11 wird die Ausnehmung 4 gemäß der Darstellung in Fig. 2b mit einer fließfähigen Vergußmasse 14 befüllt. Bei der Vergußmasse 14 kann es sich beispielsweise um ein Epoxidharz handeln. Vergußmasse 14 und Gehäusewerkstoff sind in bezug auf ihre thermischen Eigenschaften aufeinander abgestimmt, um zu vermeiden, daß thermische Belastungen, wie sie bei dem Verlöten des Bauelementes und auch im späteren Einsatzbereich auftreten können, zu mechanischen Störungen führen.

Aufgrund der Oberflächenspannung der Vergußmasse ist die Vergußmassenoberfläche 15 in Art einer Hohlkehle ausgebildet, d.h. sie weist einen konkaven Verlauf auf.

Die Füllhöhe der Vergußmasse 14 ist abhängig von dem Ausmaß der Hohlkehlenbildung, der Formgebung der im nächsten Schritt (siehe Fig. 2C) auf die Ausnehmung 4 aufzubringenden optischen Einrichtung und hängt ferner davon ab, ob gehäuseseitig Maßnahmen wie beispielsweise die hier dargestellte umlaufende Ringnut 6 getroffen sind, um gegebenenfalls randseitig übertretende Vergußmasse aufzufangen.

Fig. 2C verdeutlicht das nachfolgend durchgeführte Aufbringen einer optischen Einrichtung auf die Ausnehmung 4. In dem in Fig. 2C dargestellten Beispiel ist die optische Einrichtung in Form einer plankonvexen Sammellinse 16 ausgebildet. An der der Ausnehmung 4 zugewandten Seite weist die Sammellinse 16 im zentralen Bereiche eine ebene Grundfläche 17 auf, die sich über eine Einlaufschräge 18 in eine radial außenliegende, ringförmige Auflagefläche 19 fortsetzt. Die Grundfläche 17 ist mit der Auflagefläche 19 koplanar.

Beim Aufbringen der Linse 16 auf das gemäß Fig. 2B mit Vergußmasse 14 gefüllte Gehäuse 3 wird die Linse 16 zunächst über der Ausnehmung 4 positioniert und axial mit dieser ausgerichtet. Nachfolgend wird die Linse 16 auf das Thermoplastgehäuse 3' niedergebracht, wobei die Einlaufschräge 18 der Linse 16 mit einem oberen Bereich der geneigten Reflektor-Innenwandfläche 13 selbstzentrierend zusammenwirkt. Dadurch wird eine Endlage der Linse 16 relativ zum Gehäuse 3' erzielt, die von dem vorhergehenden Ausrichtungsschritt weitgehend unabhängig ist und im wesentlichen durch die Maßhaltigkeit der Linsen- und Gehäusefertigung in den entsprechenden Schrägflächenbereichen bestimmt wird.

Das Aufbringen der Linse 16 auf das Gehäuse 3' geschieht wie folgt: Zunächst tritt die Linsengrundfläche 17 mit der Oberfläche 15 der Vergußmasse 14 in Kontakt. Zu diesem Zeitpunkt liegt die Auflagefläche 19 noch nicht auf der Oberfläche 5 des Gehäuses 3' auf. Das nachfolgende Absenken der Linse 16 in die Endlage kann allein durch den Einfluß der Schwerkraft bewirkt werden. Dabei kommt es zu einem vollflächigen Kontakt der Linsengrundfläche 17 mit Vergußmasse 14 und - je nach Befüllungshöhe der Ausnehmung 4 (siehe Fig. 2B) - zu einer Verdrängung von Vergußmasse 14 aus der Ausnehmung 4. Über den Gehäuserand übertretende Vergußmasse sammelt sich in der Ringnut 6. Die Ringnut 6 verhindert damit ein ansonsten mögliches Herunterfließen von Vergußmasse an der Gehäuseau-ßenwandung. Ein gewisses Übertreten von Vergußmasse 14 in die Ringnut 6 kann dabei durchaus erwünscht sein, da auf diese Weise die Dichtigkeit des Verbundes zwischen der Linse 16 und dem Gehäuse 3' günstig beeinflußt wird.

In einem letzten Herstellungsschritt wird dann die Vergußmasse 14 beispielsweise im Rahmen einer Wärmebehandlung in dem Bauelement ausgehärtet.

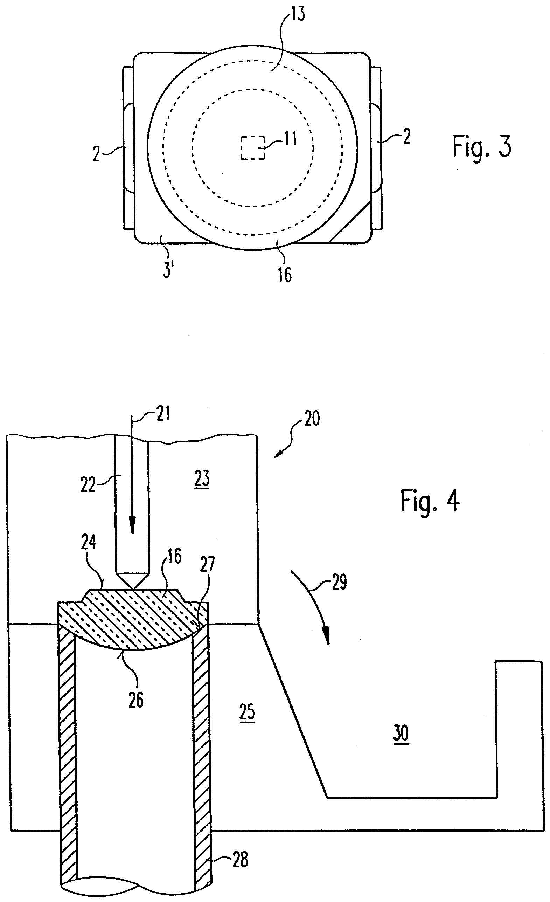

Fig. 3 zeigt das in Fig. 2C dargestellt optoelektronische Bauelement in Draufsicht. Die den Reflektor bildenden schrägen Wandflächen 13 der Ausnehmung 4 sowie der Halbleiterchip 11 befinden sich unterhalb der Linse 16 und sind durch gestrichelte Linien dargestellt. Die optionale Ringnut 6 ist aus Gründen der Übersichtlichkeit nicht eingezeichnet.

Das anhand der Fig. 2A bis 2C erläuterte Verfahren kann mit Linsen von unterschiedlicher Form und unterschiedlichem Material durchgeführt werden. Wesentlich ist jedoch, daß bei dieser Ausführungsform des erfindungsgemäßen Verfahrens die Herstellung der Linsen bereits vor Aufbringen derselben auf das Gehäuse 3, 3' abgeschlossen ist.

Fig. 4 erläutert in beispielhafter Weise die Herstellung der in Fig. 2C dargestellten plankonvexen Sammellinse 16 durch ein in einem Preßwerkzeug 20 durchgeführtes Spritzpreßverfahren. Dabei wird zunächst klare Preßmasse in Richtung des Pfeils 21 durch einen Kanal 22 einer beheizten Werkzeughälfte 23 in eine Preßfom gepreßt, die durch eine Formfläche 24 der ersten Werkzeughälfte 23, eine Formfläche 26 einer benachbart der ersten Werkzeughälfte 23 angeordneten zweiten Werkzeughälfte 25 und der Stirnfläche 27 eines in der zweiten Werkzeughälfte 25 verschieblich aufgenommenen Ringauswerfers 28 definiert ist. Die Preßmasse wird dann durch einen Preßvorgang zu der Linse 16 geformt, welche anschließend mittels des Ringauswerfers 28 im heißen Zustand gestaltfest in Richtung des Pfeils 29 aus dem Preßwerkzeug 20 ausgestoßen wird. Dabei fällt die Linse 16 als Schüttgut in einen Linsensammelbehälter 30. Der Linsensammelbehälter 30 steht in nicht dargestellter Weise mit Fördereinrichtungen, wie beispielsweise einem Rüttelförderer, Trichtern usw. in Verbindung, über die die Linse 16 zu einer ebenfalls nicht dargestellten Montageeinheit gebracht wird, mittels der sie in der bereits beschriebenen Weise (siehe Fig. 2C) auf das Gehäuse 3 des optoelektronischen Bauelements aufgebracht wird.

Bei dem nach Fig. 4 beschriebenen Linsenherstellungsverfahren erweist es sich als vorteilhaft, daß nur sehr geringe Toleranzen auftreten. Dadurch wird einerseits der Ausschuß gering gehalten und andererseits werden durch die gute Maßhaltigkeit der Linsen 16 sowohl die optischen Eigenschaften der Linse 16 als auch die Reproduzierbarkeit der Endlage der Linse 16 in dem Gehäuse 3, 3' günstig beeinflußt.

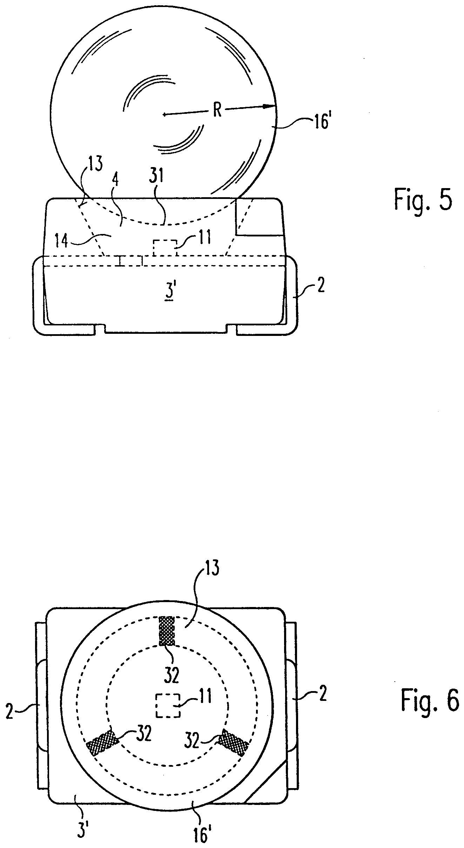

Eine Modifikation des in Fig. 2C dargestellten optoelektronischen Bauelements ist in Fig. 5 gezeigt. Das Bauelement nach Fig. 5 unterscheidet sich von dem in Fig. 2C gezeigten Bauelement im wesentlichen dadurch, daß es anstelle der plankonvexen Linse 16 eine Kugellinse 16' mit Durchmesser R aufweist.

Die Herstellung des in Fig. 5 gezeigten Bauelements erfolgt analog zu den in Fig. 2A bis 2C gezeigten Verfahrensschritten. Die Selbstzentrierung der Kugellinse 16 beim Aufbringen auf das Gehäuse 3' wird dabei durch ihre Oberflächenrundung bewirkt. Beim Aufsetzen der Linse 16' kommt der in die Ausnehmung 4 hineinstehende Kugelabschnitt 31 mit der Vergußmasse 14 in Kontakt. Durch geeignete Wahl der Füllhöhe und/oder des Radius R der Linse 16' kann erreicht werden, daß der Oberflächenverlauf des Kugelabschnitts 31 im eingesetzten Zustand gerade mit dem konvexen Verlauf der Vergußmassenoberfläche 15 korreliert. In diesem Fall erfolgt beim Aufbringen der Linse 16' im wesentlichen keine Verdrängung von Vergußmasse. Ein weiterer Vorteil des abgerundeten Kugelabschnitts 31 besteht darin, daß dieser gewährleistet, daß bei der Montage keine Luftblasen zwischen der Vergußmassenoberfläche 15 und der Linse 16' zurückbleiben kann.

Fig. 6 zeigt das in Fig. 5 dargestellte Bauelement mit Kugellinse 16' in Draufsicht. Aus dieser Figur wird deutlich, daß an den schrägen Innenwandflächen 13 der Ausnehmung 4 Radialstege 32 ausgebildet sind, die als Auflageflächen für die Kugellinse 16' dienen.

Einerseits wird durch die Radialstege 32 eine definierte und stabile Drei-Punkt-Auflage der Kugellinse 16' herbeigeführt, wodurch die Reproduzierbarkeit der Einbaulage der Kugellinse 16' relativ zum Gehäuse 3' weiter erhöht wird. Andererseits schaffen die Radialstege 32 einen ringraumartigen Freibereich zwischen der Innenfläche 13 der Ausnehmung 4 und dem Kugelabschnitts 31, der als Aufnahmevolumen für verdrängte Vergußmasse dienen kann und daher ein Übertreten von Vergußmasse über den Ausnehmungsrand hinweg auch im Falle einer ausgeprägten Verdrängung von Vergußmasse vermeidet.

Radialstege 32 oder ähnliche Auflageelemente können auch bei anderen Linsenformen und insbesondere auch bei der gemäß Fig. 2C verwendeten plankonvexen Linse 16 vorgesehen sein.

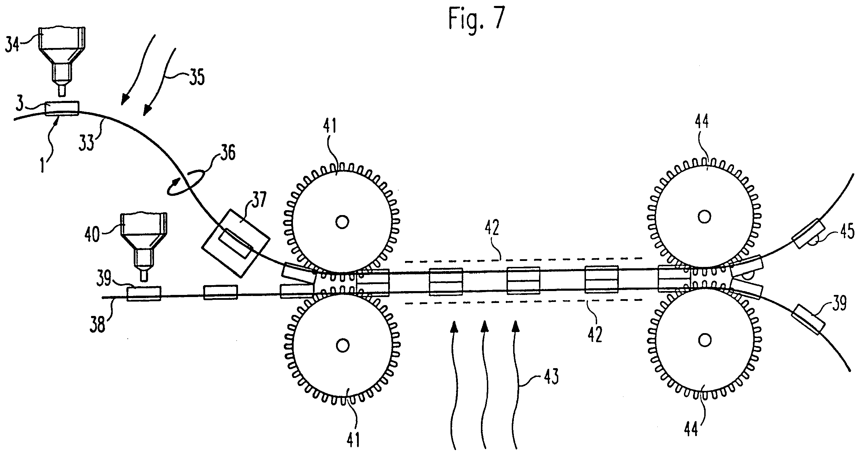

Anhand von Fig. 7 wird eine weitere Ausführungsform eines Verfahrens, das nicht durch diese Erfindung abgedeckt ist, erläutert. Der hauptsächliche Unterschied dieser zweiten Ausführungsform zu der ersten Ausführungsform besteht darin, daß die optische Einrichtung nunmehr in einem Angießverfahren auf das Bauteilgehäuse 3 aufgebracht wird.

Mit einem optischen Halbleiterchip 11 versehene Gehäuse 3 (siehe Fig. 1) werden an einem ersten Band 33 einer Gießstation 34 zugeführt, bei der die Ausnehmung 4 des Bauteilgehäuses 3 vergossen wird. Nachfolgend wird durch Wärmeeinwirkung 35 eine Aushärtung oder zumindest teilweise Anhärtung der Vergußmasse herbeigeführt. Bei 36 wird das Band 33 um 180° gewendet und bei 37 wird die nunmehr nach unten gerichtete, vergossene Oberfläche des Gehäuses zur Vorbenetzung derselben in Gießharz getaucht.

Die Benetzung der angehärteten oder ausgehärteten Vergußmasse kann auch auf anderem Wege erfolgen. Die Benetzung gewährleistet, daß der nachfolgende Angießvorgang luftblasenfrei erfolgt.

Ein zweites Band 38 trägt Gießformhälften 39, die zur Herstellung der optischen Einrichtung vorgesehen sind. Dazu werden in einer Linsengießstation 40 die Gießformhälften 39 mit einem Gießharz gefüllt. Das erste Band 33 mit den nach unten weisenden Gehäusen 3 und das zweite Band 38 mit den gefüllten Gießformhälften 39 werden zusammen durch den Spalt zwischen zwei achsparallel angeordneten Igelrädern 41 geführt und im Spalt zusammengefügt. Die Igelräder 41 sind beheizt, so daß im Spalt eine Temperatur von etwa 80°C vorliegt. Nach Verlassen des Spaltes werden die kombinierten Gehäuse-Gießformhälften 3,39 unter Einfluß einer mechanischen Führung 42 einer Wärmebehandlung 43 bei etwa 150°C unterzogen. Die Wärmebehandlung bewirkt, daß in den Gießformhälften 39 jeweils vorhandenes Vergußmaterial an die gehäuseseitige Vergußmassenoberfläche angegossen wird und daran aushärtet. Die beiden Bänder 33, 38 durchlaufen den Spalt eines zweiten Paares von Igelrädern 44, der ebenfalls auf einer Temperatur von 80°C gehalten wird. Die Entformung des Bauteils mit angegossener optischer Einrichtung 45 erfolgt ausgangsseitig des zweiten Igelradpaares 44 durch Auseinanderführen der beiden Bänder 33 und 38.

Das in Fig. 7 gezeigte Verfahren kann in folgender Weise modifiziert werden.

Anstatt auf einem Band können eine vorgegebene Anzahl von n Gießformhälften integral in einer palettenartigen Gießformgruppe zusammengefaßt sein. Nach einer entsprechenden Vorbehandlung gemäß Fig. 7 wird dann die mit Vergußmaterial befüllte Gießformgruppe von unten so an das Band 33 herangeführt, daß jede Gießformhälfte der Gießformgruppe mit einem am Band 33 angeordneten Gehäuse 3 in Kontakt gelangt. Der Zusammenhalt kann beispielsweise durch eine Klammerung bewirkt werden. Das Band 33 mit der angeklammerten Gießformgruppe wird dann ähnlich wie die Doppelbandstruktur in Fig. 7 einer Wärmebehandlung 43 bei etwa 150°C unterzogen. Nach erfolgter Aushärtung wird im Rahmen der Entformung die gesamte Gießformgruppe von dem Band 33 gelöst.

Das zuletzt erwähnte Verfahren unter Verwendung einer Gießformgruppe weist gegenüber dem in Fig. 7 gezeigten Doppelbandverfahren den Vorteil auf, daß die verwendeten Gießformgruppen etwa 200 bis 300 mal wiederverwendbar sind, während die am Band 38 geführten Gießformhälften 39 in der Regel bereits nach einigen wenigen Einsätzen ausgetauscht werden müssen. Daneben wird durch die integrale Ausbildung und somit lagefeste Anordnung der Gießformen in der Gießformgruppe eine höhere Positioniergenauigkeit erreicht, so daß die nach diesem Verfahren hergestellten optoelektronischen Bauelemente in der Regel höheren Qualitätsanforderungen genügen.

Das in Fig. 7 gezeigte Doppelbandverfahren weist hingegen den Vorteil auf, daß es aufgrund seines hohen Automatisierungsgrades sehr kostengünstig durchgeführt werden kann.

## Patentansprüche

1. Verfahren zur Herstellung eines oberflächenmontierbaren optoelektronischen Bauelements mit einem Grundkörper (1), einem in einer Ausnehmung (4) des Grundkörpers (1) angeordneten optoelektronischen Sender und/oder Empfänger (11) und einer die Ausnehmung (4) verschließenden optischen Einrichtung (16, 16', 45) mit den Schritten:
a) Herstellung des Grundkörpers (1) durch Umspritzen eines Leiterbandes (2) mit einem Thermoplastgehäuse (3) unter gleichzeitiger Ausbildung der Ausnehmung (4),
b) Montage des optoelektronischen Senders und/oder Empfängers (11) auf einen innerhalb der Ausnehmung (4) liegenden Abschnitt (9) des Leiterbandes (2),
c) Befüllen der Ausnehmung (4) des Grundkörpers (1) mit einer transparenten, härtbaren Vergußmasse (14) und
d) Aufbringen der optischen Einrichtung (16, 16') auf den Grundkörper (1), wobei
die optische Einrichtung (16, 16') auf die noch nicht gehärtete Vergußmasse (14) aufgebracht wird und die Vergußmasse (14) nachfolgend ausgehärtet wird,
**dadurch gekennzeichnet, daß**
- vor Schritt d) die folgenden Schritte ausgeführt werden:
- Herstellung der optischen Einrichtung (16, 16') mittels eines Gieß-, Preß- oder Spritzvorgangs,
- Bereitstellen und Fördern der optischen Einrichtungen (16, 16') als Schüttgut,
- automatisiertes Ergreifen jeweils einer optischen Einrichtung (16, 16') aus dem Schüttgut, und
- automatisiertes Positionieren einer optischen Einrichtung (16, 16') über einem Grundkörper (1).

2. Verfahren nach Anspruch 1,
wobei
in Schritt c) die Befüllmenge der Vergußmasse (14) so gewählt wird, daß beim nachfolgenden Aufbringen der optischen Einrichtung (16, 16') im Schritt d) im wesentlichen keine Vergußmasse (14) über den Rand der Ausnehmung (4) tritt.

3. Verfahren nach Anspruch 2,
wobei
die Ausnehmung (4) in Schritt c) bis zum Rand mit Vergußmasse (14) gefüllt wird, wobei sich nach dem Befüllen der Ausnehmung (4) aufgrund der Oberflächenspannung der Vergußmasse (14) eine Hohlkehle (15) ausbildet, und die Formgebung der optische Einrichtung (16, 16') in ihrem die Vergußmasse (14) kontaktierenden Bereich (31) so gewählt ist, daß beim nachfolgenden Aufbringen der optischen Einrichtung (16, 16') keine Vergußmasse (14) über den Rand der Ausnehmung (4) tritt.

4. Verfahren nach einem der vorhergehenden Ansprüche,
wobei
die optische Einrichtung (16, 16') in Schritt d) im Wesentlichen druckfrei von oben auf den Grundkörper (1) oder an diesem angebrachte Auflageelemente (32) aufgelegt wird, wobei die Ablage der optischen Einrichtung allein aufgrund der Schwerkraft erfolgt.

5. Verfahren nach einem der vorhergehenden Ansprüche,
wobei
die Aushärtung unter Wärmeeinwirkung erfolgt.

6. Oberflächenmontierbares optoelektronisches Bauelement mit
- einem Grundkörper (1), der aus einem Thermoplast-Spritzgehäuse (3') und einem umspritzten Leiterband (2) gebildet ist,
- ein in einer Ausnehmung (4) des Grundkörpers (1) angeordneter optoelektronischer Sender und/oder Empfänger (11), der auf einem innerhalb der Ausnehmung (4) liegenden Abschnitt (9) des Leiterbandes (2) montiert ist,
- einer in der Ausnehmung (4) vorhandenen transparenten, härtbaren Vergußmasse (14) und
- einer die Ausnehmung (4) verschließenden optischen Einrichtung (16, 16'), wobei die optische Einrichtung (16, 16') an ihrer Grundfläche (17) einen vollflächigen Kontakt mit der Vergußmasse (14) ausbildet,
**dadurch gekennzeichnet, daß**
- die optische Einrichtung (16) an der der Ausnehmung (4) zugewandten Seite im zentralen Bereich eine Grundfläche (17) aufweist, die sich über eine Einlaufschräge (18) in eine gegenüber der Grundfläche (17) zurückgesetzte radial außen liegende, ringförmige Auflagefläche (19) fortsetzt und
- die Vergußmasse (14) zwischen einer geneigten Reflektor-Innenwandfläche (13) der Ausnehmung (4) und der Einlaufschräge (18) angeordnet ist.

7. Oberflächenmontierbares optoelektronisches Bauelement nach Anspruch 6,
wobei
die Ausnehmung (4) mit einer umlaufenden Ringnut (6) versehen ist.

8. Oberflächenmontierbares optoelektronisches Bauelement nach einem der Ansprüche 6 oder 7,
wobei
der Grundkörper (1) mit randseitig zur Ausnehmung (4) angeordneten Auflageelementen (32) für die optische Einrichtung (16, 16') versehen ist.

## Claims

1. Method for producing a surface-mounted optoelectronic component with a base body (1), an optoelectronic transmitter and/or receiver (11) arranged in a recess (4) of the base body (1), and an optical device (16, 16', 45) sealing the recess (4), comprising the steps:
a) producing the base body (1) by overmolding a conductor strip (2) with a thermoplastic housing (3), simultaneously forming the recess (4),
b) mounting the optoelectronic transmitter and/or receiver (1) on a portion (9) of the conductor strip (2) located within the recess (4),
c) filling the recess (4) of the base body (1) with a transparent, curable potting compound (14), and
d) applying the optical device (16, 16 ') on to the base body (1), wherein
the optical device (16, 16') is applied on to the not yet cured casting compound (14), and the casting compound (14) is subsequently cured,
**characterized in that**
- the following steps are executed before step d):
- producing the optical device (16, 16') by means of a casting, pressing, or injection-molding process.
- providing and conveying the optical devices (16, 16') as bulk goods,
- automated picking of in each case one optical device (16, 16') out of the bulk goods, and
- automated positioning of an optical device (16, 16') above a base body (1).

2. Method according to claim 1,
wherein
in step c), the filling amount of the casting compound (14) is selected such that, substantially no casting compound (14) runs over the edge of the recess (4) during the subsequent application of the optical device (16, 16') in step d).

3. Method according to claim 2,
wherein
the recess (4) in step c) is filled up to the edge with casting compound (14), wherein a fillet (15) is formed due to the surface tension of the casting compound (14) after the filling of the recess (4), and the shape of the optical device (16,16') in its portion (31) in contact with the casting compound (14) is selected such that no casting compound (14) runs over the edge of the recess (4) during the subsequent application of the optical device (16, 16').

4. Method according to one of the preceding claims,
wherein
the optical device (16, 16') in step d) is placed, essentially without pressure, from above on to the base body (1) or on support elements (32) attached thereto, wherein the deposition of the optical device occurs solely by gravity.

5. Method according to one of the preceding claims,
wherein
the curing takes place under the influence of heat.

6. Surface-mounted optoelectronic component, comprising
- a base body (1), which is formed from a thermoplastic injection-molded housing (3') and an overmolded conductor strip (2),
- an optoelectronic transmitter and/or receiver (11) arranged in a recess (4) of the base body (1), which is mounted on a portion (9) of the conductor strip (2) located within the recess (4),
- a transparent, curable casting compound (14) present in the recess (4), and
- an optical device (16, 16') sealing the recess (4), wherein the optical device (16, 16') forms a full-surface contact with the casting compound (14) on its base area (17),
**characterized in that**
- the optical device (16) comprises a base area (17) in the central region on the side facing the recess (4), which continues in a radially outer, ring-shaped contact surface (19) recessed relative to the base area (17) through a run-in slope (18), and
- the casting compound (14) is arranged between an inclined reflector inner-wall surface (13) of the recess (4) and the run-in slope (18).

7. Surface-mounted optoelectronic component according to claim 6,
wherein
the recess (4) is provided with a circumferential annular groove (6) .

8. Surface-mounted optoelectronic component according to one of claims 6 or 7,
wherein
the base body (1) is provided with support elements (32) arranged laterally to the recess (4) for the optical device (16, 16').

## Revendications

1. Procédé de fabrication d'un composant optoélectronique pouvant être monté en surface, comprenant un corps de base (1), un émetteur et/ou récepteur (11) optoélectronique disposé dans un évidement (4) du corps de base (1), et un dispositif optique (16, 16', 45) fermant l'évidement (4), comprenant les étapes :
a) fabrication du corps de base (1) par surmoulage d'une bande conductrice (2) avec un boîtier thermoplastique (3) avec formation simultanée de l'évidement (4),
b) montage de l'émetteur et/ou récepteur (11) optoélectronique sur une partie (9) de la bande conductrice (2) située à l'intérieur de l'évidement (4),
c) remplissage de l'évidement (4) du corps de base (1) avec une masse (14) de scellement transparente durcissable, et
d) application du dispositif optique (16, 16') sur le corps de base (1),
le dispositif optique (16, 16') étant appliqué sur la masse de scellement (14) non encore durcie et la masse de scellement (14) étant ensuite durcie,
**caractérisé en ce qu'**
- avant l'étape d), les étapes suivantes sont exécutées :
- fabrication du dispositif optique (16, 16') au moyen d'une opération de moulage, pressage ou d'injection,
- fourniture et transport des dispositifs optiques (16, 16') en tant que produits en vrac,
- saisie automatisée de respectivement un dispositif optique (16, 16') dans les produits en vrac, et
- positionnement automatisé d'un dispositif optique (16, 16') au-dessus d'un corps de base (1).

2. Procédé selon la revendication 1,
dans lequel la quantité de remplissage de la masse de scellement (14), à l'étape c), est sélectionnée de manière à ce que lors de l'application suivante du dispositif optique (16, 16') à l'étape d), essentiellement pas de masse de scellement (14) ne passe au-delà du bord de l'évidement (4).

3. Procédé selon la revendication 2,
dans lequel l'évidement (4), à l'étape c), est rempli jusqu'au bord avec de la masse de scellement (14), une cannelure creuse (15) se formant après le remplissage de l'évidement (4) en raison de la tension de surface de la masse de scellement (14), et le façonnage du dispositif optique (16, 16') dans sa partie (31) en contact avec la masse de scellement (14) étant sélectionné de manière à ce que lors de l'application suivante du dispositif optique (16, 16'), pas de masse de scellement (14) ne passe au-delà du bord de l'évidement (4).

4. Procédé selon l'une quelconque des revendications précédentes,
dans lequel le dispositif optique (16, 16'), à l'étape d), est posé par le haut sur le corps de base (1) essentiellement sans pression ou sur des éléments d'appui (32) installés sur celui-ci, la pose du dispositif optique étant réalisée uniquement en raison de la gravité.

5. Procédé selon l'une quelconque des revendications précédentes,
dans lequel le durcissement est effectué sous influence thermique.

6. Composant optoélectronique pouvant être monté en surface, comprenant
- un corps de base (1) qui est formé par un boîtier en thermoplastique moulé par injection (3') et par une bande conductrice (2) surmoulée,
- un émetteur et/ou récepteur (11) optoélectronique disposé dans un évidement (4) du corps de base (1), qui est monté sur une partie (9) de la bande conductrice (2) située à l'intérieur de l'évidement (4),
- une masse de scellement (14) transparente durcissable, présente dans l'évidement (4), et
- un dispositif optique (16, 16') fermant l'évidement (4), le dispositif optique (16, 16') formant sur sa surface de base (17) un contact sur toute la surface avec la masse de scellement (14),
**caractérisé en ce que**
- le dispositif optique (16) présente sur le côté tourné vers l'évidement (4), dans la partie centrale, une surface de base (17) qui se poursuit sur une inclinaison d'entrée (18) en une surface d'appui (19) annulaire, située radialement extérieurement en retrait par rapport à la surface de base (17), et
- **en ce que** la masse de scellement (14) est disposée entre une surface (13) de paroi intérieure de réflecteur de l'évidement (4) et l'inclinaison d'entrée (18).

7. Composant optoélectronique pouvant être monté en surface selon la revendication 6,
l'évidement (4) étant pourvu d'une rainure annulaire (6) périphérique.

8. Composant optoélectronique pouvant être monté en surface selon l'une quelconque des revendications 6 ou 7,
le corps de base (1) étant pourvu d'éléments d'appui (32), disposés côté bord vers l'évidement (4), pour le dispositif optique (16, 16').
